(19) Europäisches Patentamt
European Patent Office
Office européen des brevets

(11) **EP 4 530 124 A1**

(12) **EUROPEAN PATENT APPLICATION**

(43) Date of publication:
**02.04.2025 Bulletin 2025/14**

(21) Application number: **24203003.9**

(22) Date of filing: **26.09.2024**

(51) International Patent Classification (IPC):
**B60L 58/12** (2019.01)    **B60L 58/20** (2019.01)
**G05F 1/575** (2006.01)   **G06F 1/26** (2006.01)
**G06F 1/30** (2006.01)    **H02H 3/093** (2006.01)
**H02H 3/20** (2006.01)    **H02H 3/24** (2006.01)
**H02J 1/08** (2006.01)    **H02M 1/36** (2007.01)
**H03K 17/22** (2006.01)   **B60L 53/14** (2019.01)

(52) Cooperative Patent Classification (CPC):
**H02M 1/36; B60L 53/14; B60L 58/12; B60L 58/20;
G06F 1/26; G06F 1/263; G06F 1/30; H02H 3/207;
H02H 3/243; H02H 7/18; H02J 7/06; H03K 17/22;
B60L 2210/30; B60L 2240/527; B60L 2260/20;**
(Cont.)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **27.09.2023  CN 202311279369**

(71) Applicant: **Huawei Digital Power Technologies
Co., Ltd.
Shenzhen, Guangdong 518043 (CN)**

(72) Inventors:
• **MENG, Fanyu**
  **Shenzhen, 518043 (CN)**
• **HUANG, Yaqi**
  **Shenzhen, 518043 (CN)**
• **DOU, Jiqing**
  **Shenzhen, 518043 (CN)**
• **LIANG, Tao**
  **Shenzhen, 518043 (CN)**

(74) Representative: **Gill Jennings & Every LLP
The Broadgate Tower
20 Primrose Street
London EC2A 2ES (GB)**

(54) **ON BOARD POWER SUPPLY APPARATUS AND ELECTRIC VEHICLE**

(57)    This application provides an on board power supply apparatus and an electric vehicle, which effectively resolves problems of easy damage to a switch circuit and a waste of electrical energy due to repeated turn-on of the switch circuit in the on board power supply apparatus. The on board power supply apparatus includes a first power conversion circuit and a switch module. The switch module includes a driver, a switch assembly, and a latch circuit. The first power conversion circuit is configured to receive a high-voltage direct current and output a low-voltage direct current. A low-voltage load is configured to receive the low-voltage direct current or receive an output voltage of a low-voltage power supply through the switch assembly. In a process in which the low-voltage power supply supplies power to the low-voltage load through the switch assembly, in response to a turn-off signal output by the latch circuit, the driver controls the switch assembly to break a connection between the low-voltage power supply and the low-voltage load until the latch circuit stops outputting the turn-off signal.

FIG. 2

**(Cont. next page)**

(52) Cooperative Patent Classification (CPC): (Cont.)
　　　H02H 3/066; H02J 2310/48

**Description**

**TECHNICAL FIELD**

This application relates to the field of electric vehicle charging technologies, and in particular, to an on board power supply apparatus and an electric vehicle.

**BACKGROUND**

As living standards continuously improve, electric vehicles have gradually become one of main means of transportation for people to travel. As a conversion device connecting a power grid and a power battery, an efficient and flexible on board power supply apparatus may directly influence user experience of the electric vehicles.

To reduce costs and space, most existing on board power supply apparatuses of the electric vehicles adopt a design solution in which an on board charger (on board charger, OBC) and an on board direct current/direct current (direct current/direct current, DC/DC) converter are integrated. That is, the on board charger and the on board DC/DC converter are integrated together to form an on board power supply apparatus of an electric vehicle. During actual working, the on board power supply apparatus receives an alternating current from the power grid, and converts the alternating current into a high-voltage direct current and a low-voltage direct current. The high-voltage direct current may be used to supply power to the power battery in the electric vehicle, and the low-voltage direct current is used to supply power to a low-voltage power supply (for example, a low-voltage battery) and a low-voltage load (for example, a vehicle light or a wiper) through a switch circuit in the on board power supply apparatus. In addition, when the on board power supply apparatus stops receiving the alternating current, the low-voltage power supply may be further configured to supply power to the low-voltage load through the switch circuit.

In a process in which the low-voltage power supply supplies power to the low-voltage load, when a value of an output voltage of the low-voltage power supply is normal, the switch circuit is turned on by default. That is, the switch circuit causes the low-voltage power supply to be electrically connected to the low-voltage load. In a case of an insufficient voltage of the low-voltage power supply, the low-voltage load pulls down a voltage of the low-voltage power supply, so that the value of the output voltage of the low-voltage power supply decreases slowly. When the value of the output voltage of the low-voltage power supply is lower than a specified undervoltage protection value, the switch circuit is turned off, so that the low-voltage power supply is disconnected from the low-voltage load, thereby implementing undervoltage protection. However, after the low-voltage power supply is disconnected from the low-voltage load, because no low-voltage load pulls down the voltage, the value of the output voltage of the low-voltage power supply gradually increases until the value of the output voltage of the low-voltage power supply is restored to normal. In this case, the switch circuit is turned on again, so that the low-voltage power supply is electrically connected to the low-voltage load again. Because the low-voltage power supply is still in an insufficient voltage state at this time, the value of the output voltage of the low-voltage power supply gradually decreases again until the switch circuit breaks the electrical connection between the low-voltage power supply and the low-voltage load again. Back and forth, the switch circuit is repeatedly turned on and turned off, which easily causes damage to the switch circuit. As a result, security and reliability of the on board power supply apparatus are affected.

**SUMMARY**

To resolve the foregoing problem, this application provides an on board power supply apparatus and an electric vehicle, which can effectively resolve problems of easy damage to a switch circuit and a waste of electrical energy due to repeated turn-on of the switch circuit in the on board power supply apparatus.

According to a first aspect, an embodiment of this application provides an on board power supply apparatus. The on board power supply apparatus includes a first power conversion circuit and a switch module, and the switch module includes a driver, a switch assembly, and a latch circuit. The first power conversion circuit is configured to receive a high-voltage direct current and output a low-voltage direct current. A low-voltage load is configured to receive the low-voltage direct current or receive an output voltage of a low-voltage power supply through the switch assembly. A voltage of the low-voltage direct current and an output voltage of the low-voltage power supply are less than a voltage of the high-voltage direct current. In a process in which the low-voltage power supply supplies power to the low-voltage load through the switch assembly, in response to a turn-off signal output by the latch circuit, the driver controls the switch assembly to break a connection between the low-voltage power supply and the low-voltage load until the latch circuit stops outputting the turn-off signal.

With reference to the first aspect, in a possible implementation, the switch module includes a reset circuit, and the reset circuit is configured to receive a reset indication and output a reset signal to the latch circuit. In response to that a value of the output voltage of the low-voltage power supply is less than a first voltage value or greater than a second voltage value, the latch circuit is configured to output the turn-off signal until the reset signal is received; and in response to the reset signal, the latch circuit stops outputting the turn-off signal.

In the foregoing implementation, a latch function is added to the switch circuit in the on board power supply apparatus. In this way, when the low-voltage power supply is under-voltage or over-voltage, the switch circuit breaks the connection between the low-voltage load and the low-voltage power supply and is latched. Therefore, when the low-voltage power supply restored to normal, the switch circuit does not reconnect the low-voltage power supply and the low-voltage load. This may effectively resolve problems of easy damage to the switch circuit and a waste of electrical energy due to repeated turn-on and turn-off of the switch circuit in the existing on board power supply apparatus. Power supply security and reliability of the on board power supply apparatus are high. The on board power supply apparatus is used, so that user experience of an electric vehicle may be significantly improved.

With reference to the first aspect, in a possible implementation, the switch module includes a voltage regulator, the voltage regulator is configured to receive power from the low-voltage power supply and output a first reference voltage or a second reference voltage to the latch circuit, and the first reference voltage or the second reference voltage is used to control the latch circuit to work normally. The voltage regulator is configured to provide the first reference voltage or the second reference voltage to the latch circuit based on the output voltage of the low-voltage power supply. The first reference voltage or the second reference voltage is used to control the latch circuit to work normally.

With reference to the first aspect, in a possible implementation, the on board power supply apparatus includes a housing configured to accommodate the first power conversion circuit and the switch module, and a low-voltage load interface, a low-voltage power supply interface, and a high-voltage power supply interface are disposed on a surface of the housing. The low-voltage power supply interface is electrically connected to the low-voltage load interface, the first power conversion circuit is configured to receive the high-voltage direct current through the high-voltage power supply interface, the low-voltage power supply interface is configured to receive power from the low-voltage power supply, and the low-voltage load interface is configured to electrically connect to the low-voltage load.

With reference to the first aspect, in a possible implementation, the latch circuit includes a reference voltage input terminal, a power supply voltage input terminal, a reset signal input terminal, and a turn-off signal output terminal. The latch circuit is configured to: receive an output voltage from the voltage regulator through the reference voltage input terminal, receive the reset signal from the reset circuit through the reset signal input terminal, receive the output voltage of the low-voltage power supply through the power supply voltage input terminal, and output the turn-off signal to the driver through the turn-off signal output terminal.

With reference to the first aspect, in a possible implementation, the latch circuit includes a first switch device, a second switch device, a first resistor, a second resistor, a third resistor, a fourth resistor, a first capacitor, and a voltage regulator diode.

A first end of the first switch device is configured to connect to a third end of the second switch device, a first end of the second resistor, a first end of the third resistor, and a negative electrode of the voltage regulator diode, a second end of the third resistor is connected to the power supply voltage input terminal, and a positive electrode of the voltage regulator diode is connected to the turn-off signal output terminal.

A second end of the first switch device is configured to connect to a second end of the second resistor, a first end of the first resistor, and the reset signal input terminal, and a second end of the first resistor is connected to the reference voltage input terminal.

A third end of the first switch device is configured to connect to a first end of the fourth resistor, a first end of the first capacitor, and a first end of the second switch device, and a second end of the fourth resistor, a second end of the first capacitor, and a second end of the second switch device are grounded.

In response to that the value of the output voltage of the low-voltage power supply is less than a third voltage value, both the first switch device and the second switch device are turned on, and the latch circuit is configured to output the turn-off signal. In response to that the value of output voltage of the low-voltage power supply is greater than or equal to a third voltage value, or in response to the reset signal, both the first switch device and the second switch device are turned off, and the latch circuit stops outputting the turn-off signal.

In the foregoing implementation, the latch circuit has a simple structure and low static power consumption, so that static power consumption and costs of the switch module may be reduced. In addition, values of a resistor and a capacitor in the latch circuit and a voltage regulation value of the voltage regulator are designed, so that the switch circuit can be applied to a plurality of power supply scenarios, and applicability of the switch circuit may also be improved. Therefore, the circuit structure is used, so that applicability and practicability of the on board power supply apparatus may be significantly improved.

With reference to the first aspect, in a possible implementation, the latch circuit includes a first switch device, a second switch device, a third switch device, a first resistor, a second resistor, a third resistor, a fourth resistor, a fifth resistor, a sixth resistor, a first capacitor, and a voltage regulator diode.

A first end of the first switch device is configured to connect to a third end of the second switch device, a first end of the second resistor, and a negative electrode of the voltage regulator diode, and a positive electrode of the voltage regulator diode is configured to connect to the turn-off signal output terminal.

A second end of the first switch device is configured to connect to a first end of the fifth resistor, a second end of the second resistor, a first end of the first resistor, and the reset signal input terminal, and a second end of the first resistor is configured to connect to the reference voltage input terminal.

A third end of the first switch device is configured to connect to a second end of the fifth resistor, a third end of the third switch device, a first end of the fourth resistor, a first end of the first capacitor, and a first end of the second switch device, a first end of the third switch device is configured to connect to a first end of the third resistor and a first end of the sixth resistor, and a second end of the third resistor is configured to connect to the power supply voltage input terminal.

A second end of the sixth resistor, a second end of the third switch device, a second end of the fourth resistor, a second end of the first capacitor, and a second end of the second switch device are grounded.

In response to that the value of the output voltage of the low-voltage power supply is less than a third voltage value, the third switch device is turned off, both the second switch device and the first switch device are turned on, and the latch circuit is configured to output the turn-off signal. In response to that the value of the output voltage of the low-voltage power supply is greater than or equal to a third voltage value, or in response to the reset signal, the third switch device is turned on, both the first switch device and the second switch device are turned off, and the latch circuit stops outputting the turn-off signal.

In the foregoing implementation, the latch circuit has a simple structure, which helps reduce costs of the switch module. In addition, values of a resistor and a capacitor in the latch circuit and a voltage regulation value of the voltage regulator are designed, so that the switch circuit can be applied to a plurality of power supply scenarios, and applicability of the switch circuit may also be improved. Therefore, the circuit structure is used, so that applicability and practicability of the on board power supply apparatus may be significantly improved.

With reference to the first aspect, in a possible implementation, the latch circuit includes a first switch device, a second switch device, a first resistor, a second resistor, a third resistor, a fourth resistor, a first capacitor, and a voltage regulator diode.

A first end of the first switch device is configured to connect to a third end of the second switch device, a first end of the second resistor, a first end of the third resistor, and a negative electrode of the voltage regulator diode, a second end of the third resistor is connected to the reference voltage input terminal, and a positive electrode of the voltage regulator diode is connected to the turn-off signal output terminal.

A second end of the first switch device is configured to connect to a second end of the second resistor, a first end of the first resistor, and the reset signal input terminal, and a second end of the first resistor is connected to the power supply voltage input terminal.

A third end of the first switch device is configured to connect to a first end of the fourth resistor, a first end of the first capacitor, and a first end of the second switch device, and a second end of the fourth resistor, a second end of the first capacitor, and a second end of the second switch device are grounded.

With reference to the first aspect, in a possible implementation, the latch circuit includes a first switch device, a second switch device, a first resistor, a second resistor, a third resistor, a fourth resistor, a first capacitor, and a voltage regulator diode.

A first end of the first switch device is configured to connect to a third end of the second switch device, a first end of the second resistor, and a negative electrode of the voltage regulator diode, and a positive electrode of the voltage regulator diode is configured to connect to the turn-off signal output terminal.

A second end of the first switch device is configured to connect to a first end of the second resistor, a first end of the first resistor, and the reset signal input terminal, and a second end of the first resistor is configured to connect to the reference voltage input terminal.

A third end of the first switch device is configured to connect to a first end of the third resistor, a first end of the fourth resistor, a first end of the first capacitor, and a second end of the second switch device, and a second end of the third resistor is configured to connect to the power supply voltage input terminal.

A second end of the fourth resistor, a second end of the first capacitor, and a second end of the second switch device are configured to be grounded.

With reference to the first aspect, in a possible implementation, the reset circuit includes a fourth switch device, a seventh resistor, and an eighth resistor. A first end of the fourth switch device is configured to connect to the reset signal input terminal, a second end of the fourth switch device is configured to be grounded, and a third end of the fourth switch device is configured to receive the reset indication through the seventh resistor and connect to the second end of the fourth switch device through the eighth resistor.

In the foregoing implementation, the reset circuit corresponding to the latch circuit is added to the switch circuit. In this way, a latch state of the latch circuit can be easily and conveniently released without power-off, so that the entire switch circuit is restored to a normal working state. This avoids power supply interruption caused by a manner of powering down to release the latch state, and improves reliability of the on board power supply apparatus.

With reference to the first aspect, in a possible implementation, the on board power supply apparatus further includes a rectifier circuit and a second power conversion circuit. The rectifier circuit is configured to receive an alternating current and convert the alternating current into a direct current, the second power conversion circuit is configured to convert the direct current into the high-voltage direct current and supply power to the first power conversion circuit, and the high-voltage direct current is further used to supply power to a power battery.

According to a second aspect, an embodiment of this application provides an electric vehicle, and the electric vehicle includes the on board power supply apparatus according to any one of the first aspect or the possible implementations of the first aspect.

For technical effects that can be achieved by the solution of the second aspect, refer to descriptions of technical effects that can be achieved by any one of the first aspect or the possible implementations of the first aspect. Details are not described herein again.

## BRIEF DESCRIPTION OF DRAWINGS

FIG. 1 is a diagram of a structure of an electric vehicle according to this application;

FIG. 2 is a diagram of a structure of another electric vehicle according to this application;

FIG. 3 is a diagram of a structure of an on board power supply apparatus according to this application;

FIG. 4 is a diagram of another structure of an on board power supply apparatus according to this application;

FIG. 5 is a diagram of another structure of an on board power supply apparatus according to this application;

FIG. 6 is a diagram of another structure of an on board power supply apparatus according to this application;

FIG. 7 is a diagram of another structure of an on board power supply apparatus according to this application;

FIG. 8 is a schematic of a structure of a latch circuit according to this application;

FIG. 9 is a schematic of a structure of another latch circuit according to this application;

FIG. 10 is a schematic of a structure of still another latch circuit according to this application;

FIG. 11 is a schematic of a structure of still another latch circuit according to this application;

FIG. 12 is a schematic of a structure of a reset circuit according to this application;

FIG. 13 is a diagram of another structure of an on board power supply apparatus according to this application; and

FIG. 14 is a diagram of a structure of still another electric vehicle according to this application.

## DESCRIPTION OF EMBODIMENTS

The following clearly describes technical solutions in embodiments of this application with reference to the accompanying drawings in embodiments of this application.

It may be understood that a connection relationship described in this application is a direct or indirect connection. For example, that A is connected to B may not only be that A is directly connected to B, but also be that A is indirectly connected to B through one or more other electrical components. For example, it may be that A is directly connected to C, and C is directly connected to B. In this way, A is connected to B through C. It may be further understood that "A is connected to B" described in this application may be that A is directly connected to B, or may be that A is indirectly connected to B through one or more other electrical components.

In descriptions of this application, unless otherwise specified, "/" means "or". For example, AB may mean A or B. The term "and/or" in this specification describes only an association relationship between associated objects and indicates that there may be three relationships. For example, A and/or B may represent the following three cases: Only A exists, both A and B exist, and only B exists. In descriptions of this application, the words such as "first" and "second" are merely used to distinguish between different objects, and do not limit a quantity and an execution sequence. In addition, the words such as "first" and "second" do not indicate a definite difference. In addition, the terms "including", "having", and any other variants thereof are intended to cover a non-exclusive inclusion.

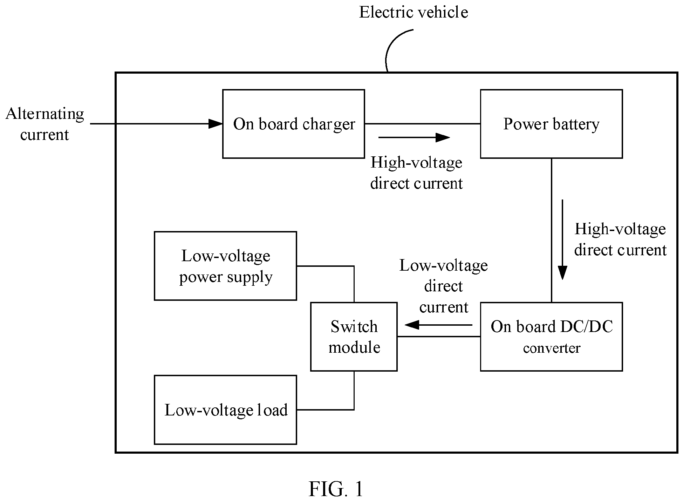

Currently, a manner of charging a power battery of an electric vehicle mainly includes fast charging and slow charging. In fast charging, the power battery is directly charged by using a direct current charging pile. In slow charging, the electric vehicle directly accesses an alternating current (alternating current, AC), and an on board charger in the electric vehicle converts the alternating current into a direct current, and then charges the power battery. During specific implementation, refer to FIG. 1. FIG. 1 is a diagram of a structure of an electric vehicle according to this application. As shown in FIG. 1, the electric vehicle mainly includes an on board charger and a power battery. Specifically, a power factor correction (power factor correction, PFC) circuit and a power conversion circuit may be disposed in the on board charger. After the power factor correction circuit converts an accessed alternating current into a bus direct current, the power conversion circuit converts the bus direct current into a high-voltage direct current and charges the power battery by using the high-voltage direct current.

Further, the electric vehicle may include an on board DC/DC converter, a switch module, a low-voltage power supply (for example, a low-voltage battery), and a low-voltage load. The on board DC/DC converter is mainly configured to convert the high-voltage direct current provided by the power battery into a low-voltage direct current, and transmit the low-voltage direct current to the low-voltage load or the low-voltage power supply through the switch module, to supply power to the low-voltage load or the low-voltage power supply. In addition, when the on board DC/DC converter stops obtaining the high-voltage direct current from the power battery, the low-voltage power supply may also supply power to the low-voltage load through the switch module. The low-voltage power supply may be an energy storage unit, for example, a low-voltage battery, that is in the electric vehicle and that can provide a stable low-voltage direct current. The low-voltage load may include various low-voltage electrical appliances such as a vehicle light and a wiper in the electric vehicle.

With continuous evolution of technologies, to reduce costs and space, the electric vehicle gradually starts to adopt a design solution in which the on board charger and the on board DC/DC converter are integrated. In other words, an on board power supply apparatus obtained by integrating the original on board charger and the on board DC/DC converter is disposed on the existing electric vehicle. The two-in-one on board power supply apparatus may charge the power battery, or may supply power to the low-voltage load in the electric vehicle or charge the low-voltage power supply in the electric vehicle.

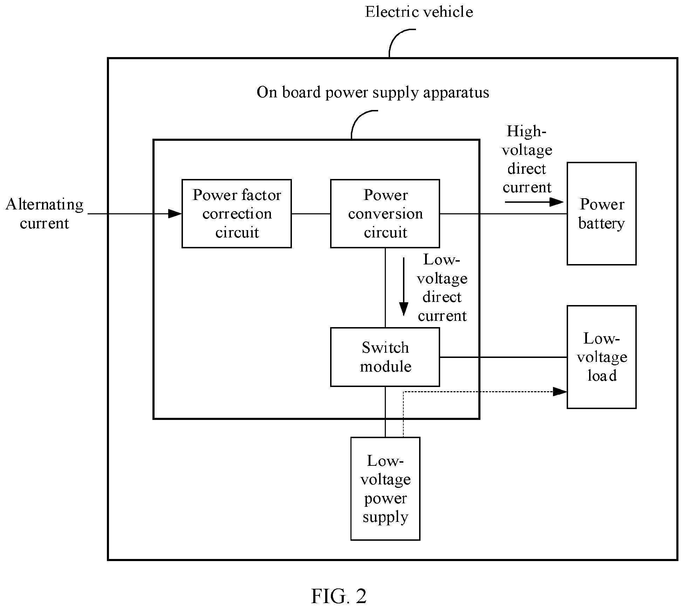

Specifically, refer to FIG. 2. FIG. 2 is a diagram of a structure of another electric vehicle according to this application. As shown in FIG. 2, the electric vehicle may include an on board power supply apparatus, a power battery, a low-voltage load, and a low-voltage power supply. The on board power supply apparatus mainly includes a power factor correction circuit, a power conversion circuit, and a switch module. During actual working, the on board power supply apparatus receives an alternating current from a power grid, and converts the alternating current into a high-voltage direct current and a low-voltage direct current through the power factor correction circuit and the power conversion circuit. The high-voltage direct current may be used to supply power to the power battery in the electric vehicle, and the low-voltage direct current is used to supply power to the low-voltage power supply and the low-voltage load through the switch module in the on board power supply device. In addition, when the on board power supply apparatus stops receiving the alternating current, the low-voltage power supply may be further configured to supply power to the low-voltage load through the switch module.

For the electric vehicle shown in FIG. 1 or FIG. 2, in a process in which the low-voltage power supply supplies power to the low-voltage load, when a value of an output voltage of the low-voltage power supply is normal, the switch module is turned on by default. That is, the low-voltage load supplies power to the low-voltage load through the switch module. In a case of an insufficient voltage of the low-voltage power supply, the low-voltage load pulls down a voltage of the low-voltage power supply, so that the value of the output voltage of the low-voltage power supply decreases slowly. When the value of the output voltage of the low-voltage power supply is lower than a specified undervoltage protection point, the switch module is turned off, so that the low-voltage power supply is disconnected from the low-voltage load, thereby implementing undervoltage protection. However, after the low-voltage power supply is disconnected from the low-voltage load, because no low-voltage load pulls down the voltage, the value of the output voltage of the low-voltage power supply gradually increases until the value of the output voltage of the low-voltage power supply is restored to normal. In this case, the switch module is turned on again, so that the low-voltage power supply is electrically connected to the low-voltage load again. Because the low-voltage power supply is still in an insufficient voltage state at this time, the value of the output voltage of the low-voltage power supply gradually decreases again until the switch module breaks the electrical connection between the low-voltage power supply and the low-voltage load again. Back and forth, the switch module is repeatedly turned on and turned off. This not only easily causes damage to the switch module, but also causes a waste of electrical energy.

In view of this, this application provides a new on board power supply apparatus, to resolve problems of easy damage to a switch circuit and a waste of electrical energy due to repeated turn-on and turn-off of the switch module in an existing power supply solution. The switch module in the on board power supply apparatus includes a driver, a switch assembly, and a latch circuit. In a case of undervoltage of a low-voltage power supply, the driver can control, based on an output voltage of the low-voltage power supply, the switch assembly to break a connection between the low-voltage power supply and a low-voltage load. In addition, the latch circuit also continuously provides a turn-off signal to the driver, so that the driver continuously controls the switch assembly to break the connection between low-voltage power supply and the low-voltage load. Because of effect of the latch circuit, after the connection is broken, even if the low-voltage power supply is restored to a non-undervoltage state, the switch module does not re-establish the connection between the low-voltage power supply and the low-voltage load. This may resolve a problem that the switch module is repeatedly turned on.

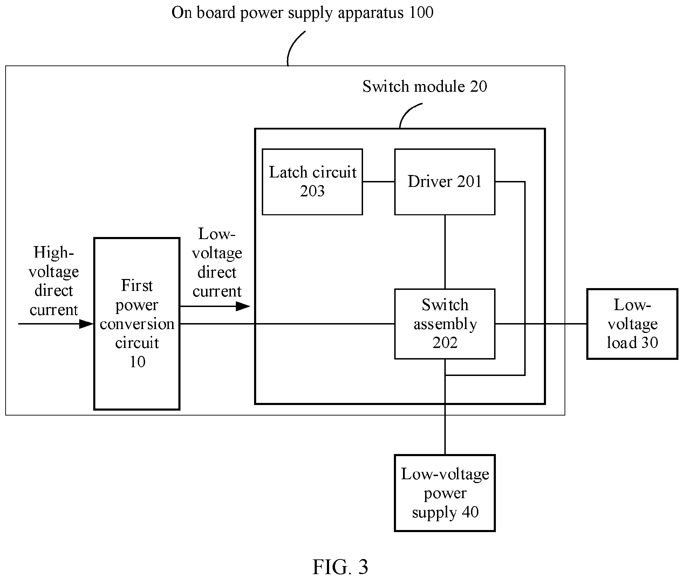

With reference to FIG. 3 to FIG. 13, the following describes in detail a structure and a function of an on board power supply apparatus that may be applied to an electric vehicle and that is provided in this application.

FIG. 3 is a diagram of a structure of an on board power supply apparatus according to this application. As shown in FIG. 3, the on board power supply apparatus 100 may include a first power conversion circuit 10 and a switch module 20. The switch module 20 may include a driver 201, a switch assembly 202, and a latch circuit 203. The switch assembly 202 is separately connected to the driver 201, the first power conversion circuit 10, a low-voltage load 30, and a low-voltage power supply 40. The latch circuit 203 is connected to the driver 201.

During actual working, the first power conversion circuit 10 may be configured to convert a high-voltage direct current received by the first power conversion circuit 10 into a low-voltage direct current. The low-voltage direct current or the low-voltage power supply 40 may be configured to supply power to the low-voltage load 30 through the switch assembly 202. In other words, the first power conversion circuit 10 may provide the low-voltage direct current to the low-voltage load 30 or the low-voltage power supply 40 through the switch assembly 202. When the first power conversion circuit 10 does not access the high-voltage direct current, the low-voltage power supply 40 may also be configured to supply power to the low-voltage load 30 through the switch assembly 202. A voltage of the low-voltage direct current and an output voltage of the low-voltage power supply 40 are less than a voltage of the high-voltage direct current.

In a process in which the low-voltage power supply 40 supplies power to the low-voltage load 30, in response to a turn-off signal output by the latch circuit 203, the driver 201 controls the switch assembly 202 to break a connection between the low-voltage power supply 40 and the low-voltage load 30 until the latch circuit 203 stops outputting the turn-off signal. It may be understood that a first voltage value is an undervoltage protection value of the low-voltage power supply 40. In response to that the output voltage of the low-voltage power supply 40 is less than the preset first voltage value, the driver 201 further controls the switch assembly 202 to break the connection between the low-voltage power supply 40 and the low-voltage load 30. In response to that the output voltage of the low-voltage power supply 40 is greater than or equal to the first voltage value, the latch circuit 203 stops outputting the turn-off signal, and the driver 201 further controls the switch assembly 202 to establish the connection between the low-voltage power supply 40 and the low-voltage load 30.

It should be understood that, in the process in which the low-voltage power supply 40 supplies power to the low-voltage load 30, the latch circuit 203 determines, based on a value of the output voltage of the low-voltage power supply 40, whether to provide the turn-off signal to the driver 201. Optionally, when the output voltage of the low-voltage power supply 40 is less than the first voltage value, the latch circuit 203 continuously provides the turn-off signal to the driver 201, and stops providing the turn-off signal to the driver 201 until the latch circuit 203 receives a reset indication.

In the foregoing implementation, a latch function is added to the switch module 20 in the on board power supply apparatus 100. In this way, when the low-voltage power supply 40 is under-voltage, the switch module 20 breaks the connection between the low-voltage load 30 and the low-voltage power supply 40 and is latched. Therefore, when the low-voltage power supply 40 is restored to normal, the switch module 20 does not reconnect the low-voltage power supply 40 and the low-voltage load 30. This may effectively resolve problems of damage to electrical components and a waste of electrical energy due to repeated turn-on and turn-off of the switch module 20 in the existing on board power supply apparatus. Power supply security and reliability of the on board power supply apparatus 100 are high. The on board power supply apparatus 100 is used, so that user experience of an electric vehicle may be significantly improved.

For example, the switch assembly 202 may include at least one controllable switch device. When the driver 201 normally drives the switch assembly 202, the at least one controllable switch device is in a turn-on state. In this case, the low-voltage power supply 40 is normally electrically connected to the low-voltage load 30. When the driver 201 stops driving the switch assembly 202, the at least one controllable switch device is in a turn-off state. In this case, the low-voltage power supply 40 is electrically disconnected from the low-voltage load 30.

For example, the low-voltage load 30 may include at least one of the following: a vehicle light, a wiper, an air conditioner, a stereo, a USB interface, a dashboard, and a control display screen. The low-voltage power supply 40 may include a low-voltage battery, for example, an on board 12 V battery.

In some feasible implementations, in response to that the output voltage of the low-voltage power supply is greater than a second voltage value, or in response to the turn-off signal provided by the latch circuit 203, the driver 201 controls the switch assembly 202 to break the connection between the low-voltage power supply 40 and the low-voltage load 30. In response to that the output voltage of the low-voltage power supply 40 is less than or equal to a second voltage value, the latch circuit 203 stops outputting the turn-off signal, and the driver 201 further controls the switch assembly 202 to establish the connection between the low-voltage power supply 40 and the low-voltage load 30. Optionally, in this case, when the output voltage of the low-voltage power supply 40 is greater than the second voltage value, the latch circuit 203 continuously provides the turn-off signal to the driver 201, and stops providing the turn-off signal to the driver 201 until the latch circuit 203 receives a reset indication.

In the foregoing implementation, when the low-voltage power supply 40 is over-voltage, the driver 201 controls the switch assembly 202 to break the connection between the low-voltage load 30 and the low-voltage power supply 40. In addition, because of effect of the latch circuit 203, when the low-voltage power supply 40 is restored to normal, the low-voltage power supply 40 and the low-voltage load 30 are not connected again. This may also resolve problems of damage to electrical components and a waste of electrical energy due to repeated turn-on and turn-off of the switch module 20 in the existing on board power supply apparatus.

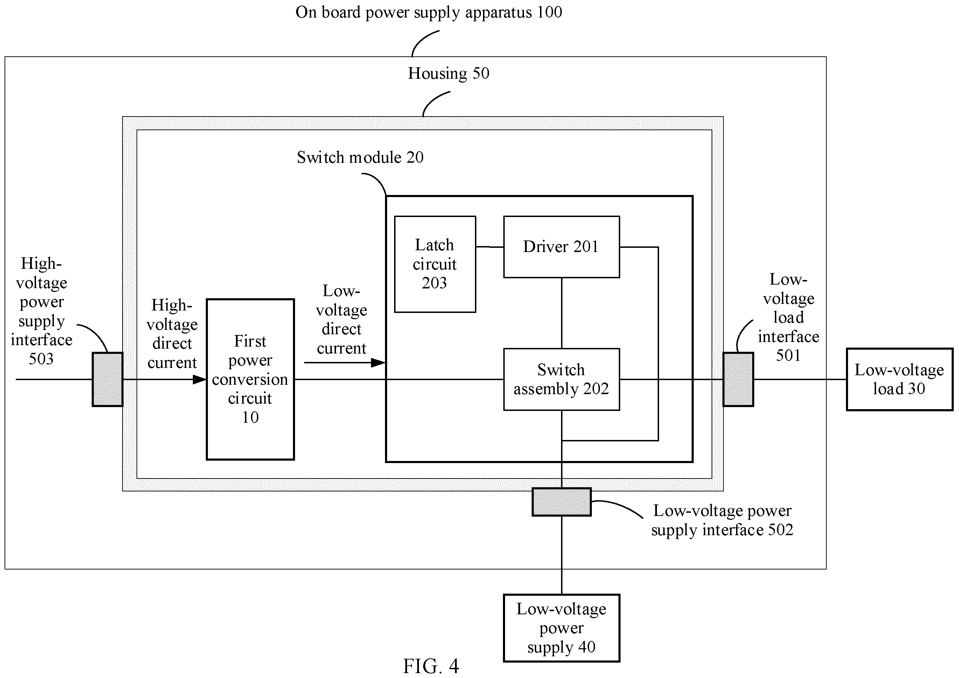

In some feasible implementations, refer to FIG. 4. FIG. 4 is a diagram of another structure of an on board power supply apparatus according to this application. As shown in FIG. 4, the on board power supply apparatus 100 includes a housing 50 configured to accommodate the first power conversion circuit 10 and the switch module 20. In addition, a low-voltage load interface 501, a low-voltage power supply interface 502, and a high-voltage power supply interface 503 are disposed on a surface of the housing 50. The low-voltage power supply interface 502 is electrically connected to the low-voltage load interface 501 through the switch assembly 202. The first power conversion circuit 10 is configured to receive the high-voltage direct current through the high-voltage power supply interface 503. The low-voltage power supply interface 502 is configured to receive power from the low-voltage power supply 40. In other words, the low-voltage power supply interface 502 is configured to connect to the low-voltage power supply 40. The low-voltage load interface 501 is configured to electrically connect to the low-voltage load 30.

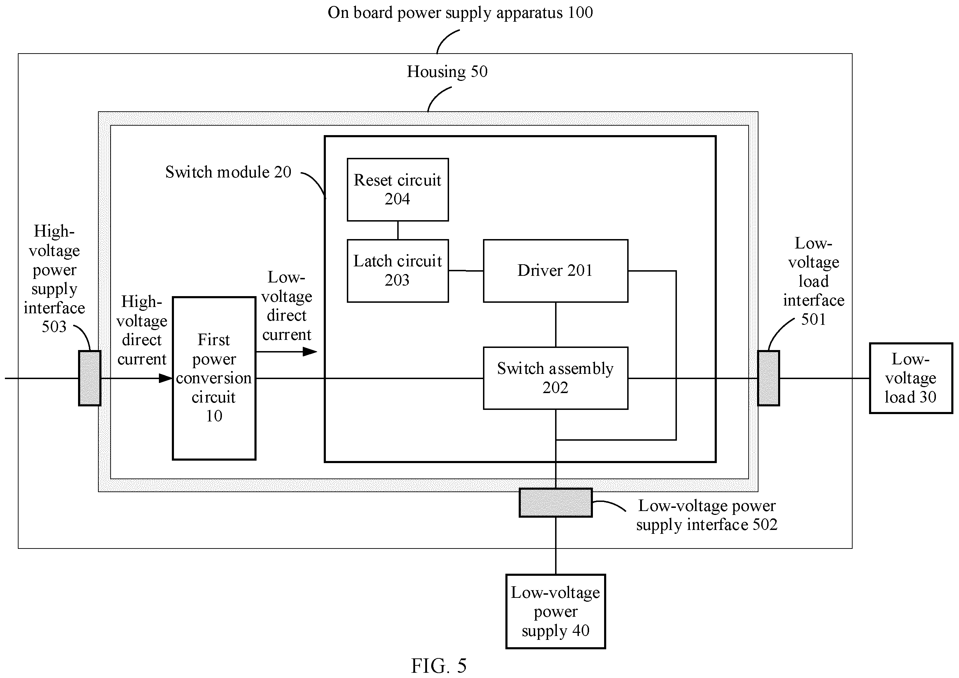

In some feasible implementations, refer to FIG. 5. FIG. 5 is a diagram of another structure of an on board power supply apparatus according to this application. As shown in FIG. 5, the switch module 20 may further include a reset circuit 204. The reset circuit 204 is connected to the latch circuit 203.

During actual working, the reset circuit 204 is configured to receive the reset indication, and output a reset signal to the latch circuit 203. In response to the reset signal, the latch circuit 203 stops outputting the turn-off signal to the driver 201. It may also be understood that, the reset circuit 204 is configured to restore a circuit status of the latch circuit 203 to an initial state after receiving the reset indication, so that the latch circuit 203 stops providing the turn-off signal to the driver 201. Correspondingly, when no reset indication is received, the reset circuit 204 does not output the reset signal to the latch circuit 203.

In the foregoing implementation, the reset circuit 204 corresponding to the latch circuit 203 is added to the switch module 20. In this way, a latch state of the latch circuit 203 can be easily and conveniently released without power-off, so that the entire switch module 20 is restored to a normal working state. This avoids power supply interruption caused by a manner of powering down to release the latch state, and improves reliability of the on board power supply apparatus 100.

It should be understood that, during actual working, the on board power supply apparatus 100 may include a controller, and the controller may be used by the on board power supply apparatus 100 to perform corresponding control on some components included in the on board power supply apparatus 100. In view of this, in a possible implementation, the reset indication may be sent by the controller in the on board power supply apparatus 100 to the reset circuit 204. For example, when the controller in the on board power supply apparatus 100 determines that a fault point that causes overvoltage or undervoltage of the low-voltage power supply 40 has been rectified, the driver 201 does not repeatedly control the switch assembly 202 to be turned on and turned off. In this case, the reset signal may be sent to the reset circuit 204, so that the latch circuit 203 is released from the latch state, and stops providing the turn-off signal to the driver 201.

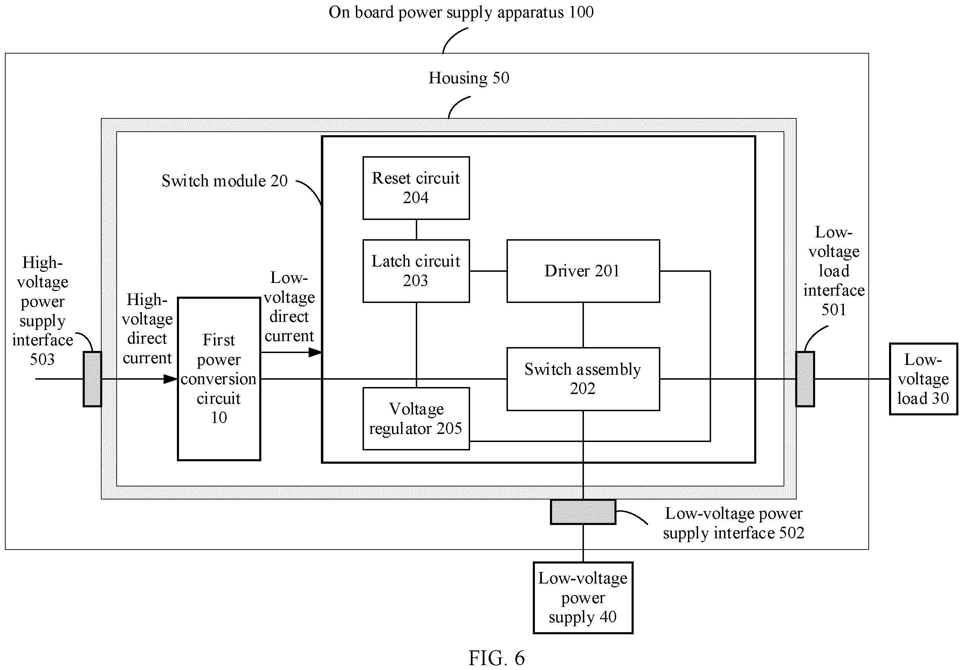

In some feasible implementations, refer to FIG. 6. FIG. 6 is a diagram of another structure of an on board power supply apparatus according to this application. As shown in FIG. 6, the switch module 20 may further include a voltage regulator 205. The voltage regulator 205 is separately connected to the low-voltage power supply interface 502 and the latch circuit 203.

In the process in which the low-voltage power supply 40 supplies power to the low-voltage load 30, the voltage regulator 205 may be configured to provide a first reference voltage or a second reference voltage to the latch circuit 203 based on the output voltage of the low-voltage power supply 40. Herein, the first reference voltage or the second reference voltage is used to support the latch circuit 203 in working normally. In other words, the latch circuit 203 can work normally only after accessing the first reference voltage or the second reference voltage.

Optionally, in response to that the value of the output voltage of the low-voltage power supply 40 is less than a preset third voltage value or greater than a preset fourth voltage value, the latch circuit 203 may output the turn-off signal to the driver 201 and is latched. The third voltage value should be greater than the first voltage value, and the fourth voltage value should be less than the second voltage value. It may be understood that the third voltage value is an undervoltage protection value specified by the latch circuit 203, and the fourth voltage value is an overvoltage protection value specified by the latch circuit 203. Herein, that the latch circuit 203 outputs the turn-off signal to the driver 201 and is latched may be understood that the latch circuit 203 enters the latch state while outputting the turn-off signal to the driver 201. A turn-off state of the controllable switch device included in the latch circuit 203 remains. Therefore, the latch circuit 203 may continuously provide the turn-off signal to the switch module 20. The latch circuit 203 stops outputting the turn-off signal to the driver 201 until the latch circuit 203 receives the reset signal from the reset circuit 204 and the turn-off state of the controllable switch device included in the latch circuit 203 is reset.

In other words, when the switch module 20 has an undervoltage protection function, in the process in which the low-voltage power supply 40 supplies power to the low-voltage load 30, the voltage regulator 205 may generate the first reference voltage based on the power supply of the low-voltage power supply 40, and provide the first reference voltage to the latch circuit 203, so that the latch circuit 203 can work normally. The latch circuit 203 may continuously output the turn-off signal to the driver 201 after it is detected that the value of the output voltage of the low-voltage power supply 40 is less than the third voltage value, and may stop outputting the turn-off signal to the driver 201 until the latch circuit 203 is reset. If the driver 201 receives the turn-off signal from the latch circuit 203, or it is detected that the value of the output voltage of the low-voltage power supply 40 is less than the first voltage value, the switch assembly 202 may be controlled to break the connection between the low-voltage power supply 40 and the low-voltage load 30.

When the switch module 20 has an overvoltage protection function, in the process in which the low-voltage power supply 40 supplies power to the low-voltage load 30, the voltage regulator 205 may generate the second reference voltage based on the power supply of the low-voltage power supply 40, and provide the second reference voltage to the latch circuit 203, so that the latch circuit 203 can work normally. The latch circuit 203 may continuously output the turn-off signal to the driver 201 after it is detected that the value of the output voltage of the low-voltage power supply 40 is greater than the fourth voltage value, and may stop outputting the turn-off signal to the driver 201 until the latch circuit 203 is reset. If the driver 201 receives the turn-off signal from the latch circuit 203, or it is detected that the value of the output voltage of the low-voltage power supply 40 is greater than the second voltage value, the switch assembly 202 may be controlled to break the connection between the low-voltage power supply 40 and the low-voltage load 30.

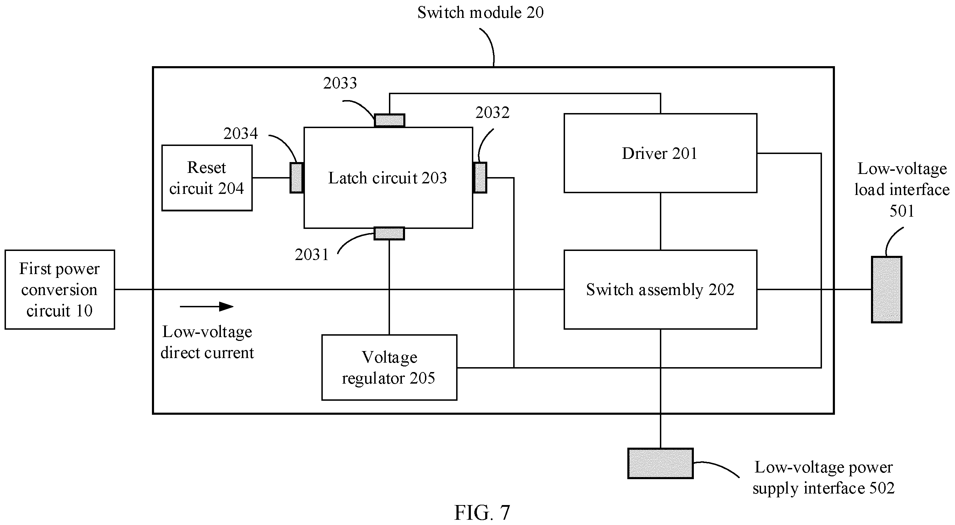

In some feasible implementations, refer to FIG. 7. FIG. 7 is a diagram of another structure of an on board power supply apparatus according to this application. As shown in FIG. 7, the latch circuit 203 may include a reference voltage input terminal 2031, a power supply voltage input terminal 2032, a reset signal input terminal 2034, and a turn-off signal output terminal 2033. The latch circuit 203 may receive an output voltage from the voltage regulator through the reference voltage input terminal 2031. The output voltage may include the first reference voltage or the second reference voltage. The latch circuit 203 may receive the reset signal from the reset circuit 204 through the reset signal input terminal 2034. The latch circuit 203 may further receive the output voltage of the low-voltage power supply 40 through the power supply voltage input terminal 2032. The latch circuit may output the turn-off signal to the driver 201 through the turn-off signal output terminal 2033.

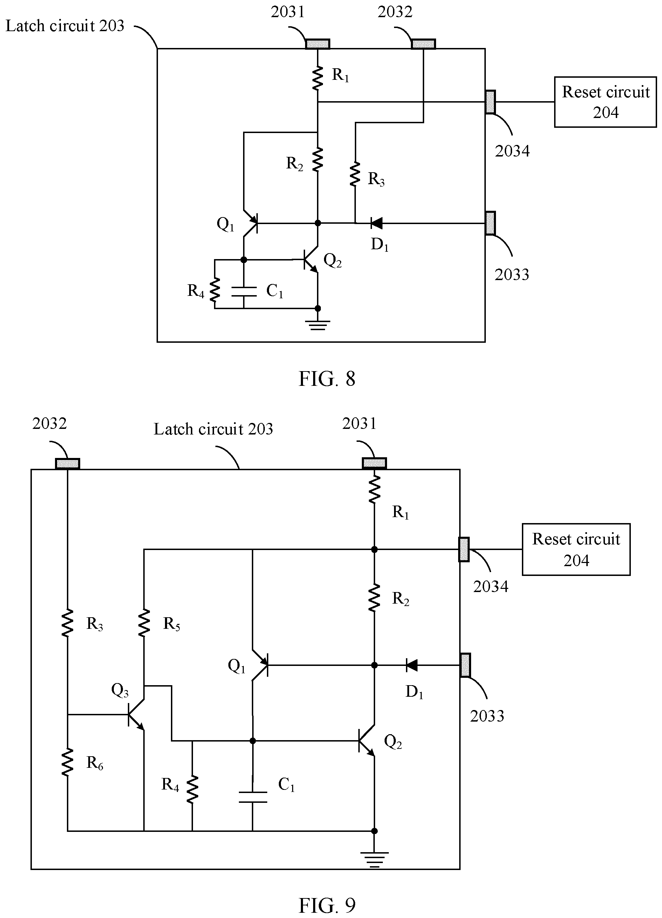

In some feasible implementations, refer to FIG. 8. FIG. 8 is a schematic of a structure of a latch circuit according to this application. As shown in FIG. 8, the latch circuit 203 includes a first switch device $Q_1$, a second switch device $Q_2$, a first resistor $R_1$, a second resistor $R_2$, a third resistor $R_3$, a fourth resistor $R_4$, a first capacitor $C_1$, and a voltage regulator diode $D_1$.

A first end of the first switch device $Q_1$ is configured to connect to a third end of the second switch device $Q_2$, a first end of the second resistor $R_2$, a first end of the third resistor $R_3$, and a negative electrode of the voltage regulator diode $D_1$. A second end of the third resistor $R_3$ is connected to the power supply voltage input terminal 2032, and a positive electrode of the voltage regulator diode $D_1$ is connected to the turn-off signal output terminal 2033. A second end of the first switch device $Q_1$ is configured to connect to a second end of the second resistor $R_2$, a first end of the first resistor $R_1$, and

the reset signal input terminal 2034, and a second end of the first resistor $R_1$ is connected to the reference voltage input terminal 2031. A third end of the first switch device $Q_1$ is configured to connect to a first end of the fourth resistor $R_4$, a first end of the first capacitor $C_1$, and a first end of the second switch device $Q_2$. A second end of the fourth resistor $R_4$, a second end of the first capacitor $C_1$, and a second end of the second switch device $Q_2$ are grounded.

During actual working, when the switch module 20 has an undervoltage protection function, in response to that the value of the output voltage of the low-voltage power supply 40 is less than the third voltage value, the first switch device $Q_1$ and the second switch device $Q_2$ are turned on and mutually latched, so that the latch circuit 203 can continuously provide the turn-off signal to the driver 201. Specifically, because of voltage division effect of the first resistor $R_1$, the second resistor $R_2$, and the third resistor $R_3$, when the value of the output voltage of the low-voltage power supply 40 is less than the third voltage value, the first switch device $Q_1$ is turned on, and the second switch device $Q_2$ is also turned on after the first switch device $Q_1$ is turned on. Because the second switch device $Q_2$ is turned on, a level at the voltage regulator diode $D_1$ is pulled down, and the low-level signal is provided to the driver 201 as a turn-off signal. In addition, after the second switch device $Q_2$ is turned on, because a base voltage of the first switch device $Q_1$ is pulled down, even if the value of the output voltage of the low-voltage power supply 40 is restored to being greater than or equal to the third voltage value, the first switch device $Q_1$ still remains in a turn-on state. However, that the first switch device $Q_1$ is turned on may also cause the second switch device $Q_2$ to be turned on. Therefore, the first switch device $Q_1$ and the second switch device $Q_2$ are mutually latched (which may be understood that the latch circuit 203 is latched). The latch circuit 203 may continuously provide the turn-off signal to the driver 201, so that the driver 201 controls the switch assembly 202 to continuously break the connection between the low-voltage load 30 and the low-voltage power supply 40. Until the latch circuit 203 is released from the latch state and stops providing the turn-off signal to the driver 201, the driver 201 can again control, based on the value of the output voltage of the low-voltage power supply 40, the connection between the low-voltage power supply 40 and the low-voltage load 30 to be established or broken.

Further, based on the structure shown in FIG. 8, there is a fixed association relationship between the third voltage value and a value of the first reference voltage. Specifically, the third voltage value and the value of the first reference voltage may satisfy the following formula:

$$V_1 = V_{ref} - V_{d1} \times \left( \frac{r_1 + r_2 + r_3}{r_2} \right) \quad (1)$$

$V_1$ is the third voltage value, $V_{ref1}$ is the value of the first reference voltage, $V_{d1}$ is a turn-on voltage value of the first switch device $Q_1$, $r_1$ is a resistance value of the first resistor $R_1$, $r_2$ is a resistance value of the second resistor $R_2$, and $r_3$ is a resistance value of the third resistor $R_3$.

It should be noted that, during actual implementation, when a turn-on/turn-off speed of the first switch device $Q_1$ is not affected, the resistance value of the second resistor $R_2$ is greater than or equal to a preset resistance value. This is because when both the first switch device $Q_1$ and the second switch device $Q_2$ are turned off, a quiescent current is limited by the first resistor $R_1$, the second resistor $R_2$, and the third resistor $R_3$. The second resistor $R_2$ with a relatively large resistance value is used, so that static power consumption of the latch circuit 203 can be effectively reduced, and energy consumption of the on board power supply apparatus 100 is further reduced.

In the foregoing implementation, the latch circuit 203 has a simple structure and low static power consumption, so that static power consumption and costs of the switch module 20 may be reduced. In addition, values of a resistor and a capacitor in the latch circuit 203 and a voltage regulation value of the voltage regulator 205 are designed, so that the switch module 20 can be applied to a plurality of power supply scenarios, and applicability of the switch module 20 may also be improved. Therefore, the circuit structure is used, so that applicability and practicability of the on board power supply apparatus 100 may be significantly improved.

In some feasible implementations, refer to FIG. 9. FIG. 9 is a schematic of a structure of another latch circuit according to this application. As shown in FIG. 9, the latch circuit 203 includes a first switch device $Q_1$, a second switch device $Q_2$, a third switch device $Q_3$, a first resistor $R_1$, a second resistor $R_2$, a third resistor $R_3$, a fourth resistor $R_4$, a fifth resistor $R_5$, a sixth resistor $R_6$, a first capacitor $C_1$, and a voltage regulator diode $D_1$.

A first end of the first switch device $Q_1$ is configured to connect to a third end of the second switch device $Q_2$, a first end of the second resistor $R_2$, and a negative electrode of the voltage regulator diode $D_1$. A positive electrode of the voltage regulator diode $D_1$ is configured to connect to the turn-off signal output terminal 2033. A second end of the first switch device $Q_1$ is configured to connect to a first end of the fifth resistor $R_5$, a second end of the second resistor $R_2$, a first end of the first resistor $R_1$, and the reset signal input terminal 2034, and a second end of the first resistor $R_1$ is configured to connect to the reference voltage input terminal 2031. A third end of the first switch device $Q_1$ is configured to connect to a second end of the fifth resistor $R_5$, a third end of the third switch device $Q_3$, a first end of the fourth resistor $R_4$, a first end of the first capacitor $C_1$, and a first end of the second switch device $Q_2$. A first end of the third switch device $Q_3$ is configured to connect to a first end of the third resistor $R_3$ and a first end of the sixth resistor $R_6$, and a second end of the third resistor $R_3$ is configured to connect to the power supply voltage input terminal 2032.

A second end of the sixth resistor $R_6$, a second end of the third switch device $Q_3$, a second end of the fourth resistor $R_4$, a second end of the first capacitor $C_1$, and a second end of the second switch device $Q_2$ are grounded.

During actual working, when the switch module 20 has an undervoltage protection function, in response to that the value of the output voltage of the low-voltage power supply 40 is less than the third voltage value, the third switch device $Q_3$ is turned off, and the second switch device $Q_2$ and the first switch device $Q_1$ are turned on and mutually latched, so that the latch circuit 203 continuously provides the turn-off signal to the driver 201. Specifically, when the value of the output voltage of the low-voltage power supply 40 is normal, because of a voltage division relationship between the third resistor $R_3$ and the sixth resistor $R_6$, the third switch device $Q_3$ is turned on, the second switch device $Q_2$ cannot be turned on because a base voltage of the second switch device $Q_2$ is pulled down, and the first switch device $Q_1$ cannot be turned on either. When the value of the output voltage of the low-voltage power supply 40 is less than the third voltage value, voltage division between the third resistor $R_3$ and the sixth resistor $R_6$ causes the third switch device $Q_3$ to change from being turned on to being turned off. When the third switch device $Q_3$ is turned off, voltage division of the first resistor $R_1$, the fourth resistor $R_4$, and the fifth resistor $R_5$ causes the second switch device $Q_2$ to be turned on. After the second switch device $Q_2$ is turned on, a base voltage of the first switch device $Q_1$ is pulled down, and the first switch device $Q_1$ is also turned on. Because $Q_2$ is turned on, a level at the voltage regulator diode $D_1$ is pulled down, and the low-level signal is provided to the driver 201 as a turn-off signal. In addition, after the first switch device $Q_1$ is turned on, because the base voltage of the second switch device $Q_2$ is pulled up, even if the value of the output voltage of the low-voltage power supply 40 is restored to being greater than or equal to the third voltage value, the second switch device $Q_2$ still remains in a turn-on state. However, that the second switch device $Q_2$ is turned on may also cause the first switch device $Q_1$ to be turned on. Therefore, the first switch device $Q_1$ and the second switch device $Q_2$ are mutually latched (in this case, it may also be understood that the latch circuit 203 is latched). The latch circuit 203 may continuously provide the turn-off signal to the driver 201, so that the driver 201 controls the switch assembly 202 to continuously break the connection between the low-voltage load 30 and the low-voltage power supply 40. Until the latch circuit 203 is released from the latch state and stops providing the turn-off signal to the driver 201, the driver 201 can again control, based on the value of the output voltage of the low-voltage power supply 40, the connection between the low-voltage power supply 40 and the low-voltage load 30 to be established or broken.

Further, based on the structure shown in FIG. 9, the third voltage value satisfies the following formula:

$$V_1 = V_{d3} \times \left(\frac{r_3 + r_6}{r_6}\right) \qquad (2)$$

$V_1$ is the third voltage value, $V_{d3}$ is a turn-on voltage value of the third switch device $Q_3$, $r_3$ is a resistance value of the third resistor $R_3$, and $r_6$ is a resistance value of the sixth resistor $R_6$.

In the foregoing implementation, the latch circuit 203 has a simple structure, which helps reduce costs of the switch module 20. In addition, values of a resistor and a capacitor in the latch circuit 203 and a voltage regulation value of the voltage regulator 205 are designed, so that the switch module 20 can be applied to a plurality of power supply scenarios, and applicability of the switch module 20 may also be improved. Therefore, the circuit structure is used, so that applicability and practicability of the on board power supply apparatus 100 may be significantly improved.

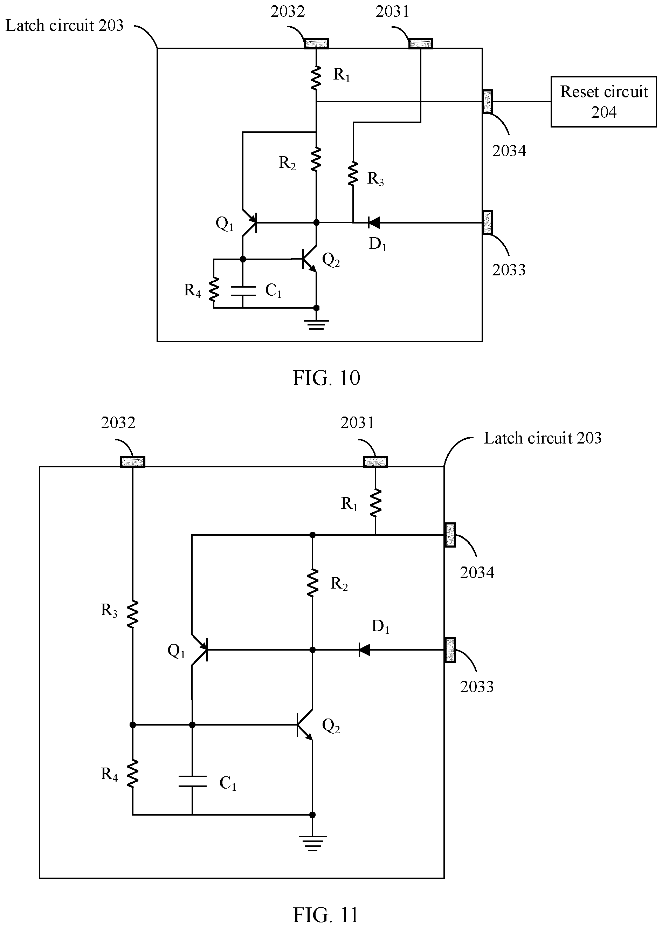

In some feasible implementations, refer to FIG. 10. FIG. 10 is a schematic of a structure of still another latch circuit according to this application. As shown in FIG. 10, the latch circuit 203 includes a first switch device $Q_1$, a second switch device $Q_2$, a first resistor $R_1$, a second resistor $R_2$, a third resistor $R_3$, a fourth resistor $R_4$, a first capacitor $C_1$, and a voltage regulator diode $D_1$.

A first end of the first switch device $Q_1$ is configured to connect to a third end of the second switch device $Q_2$, a first end of the second resistor $R_2$, a first end of the third resistor $R_3$, and a negative electrode of the voltage regulator diode $D_1$, a second end of the third resistor $R_3$ is connected to the reference voltage input terminal 2031, and a positive electrode of the voltage regulator diode $D_1$ is connected to the turn-off signal output terminal 2033. A second end of the first switch device $Q_1$ is configured to connect to a second end of the second resistor $R_2$, a first end of the first resistor $R_1$, and the reset signal input terminal 2034, and a second end of the first resistor $R_1$ is connected to the power supply voltage input terminal 2032. A third end of the first switch device $Q_1$ is configured to connect to a first end of the fourth resistor $R_4$, a first end of the first capacitor $C_1$, and a first end of the second switch device $Q_2$, and a second end of the fourth resistor $R_4$, a second end of the first capacitor $C_1$, and a second end of the second switch device $Q_2$ are grounded.

During actual working, when the switch module 20 has an overvoltage protection function, in response to that the value of the output voltage of the low-voltage power supply 40 is greater than the fourth voltage value, the first switch device $Q_1$ and the second switch device $Q_2$ are turned on and mutually latched, so that the latch circuit 203 continuously provides the turn-off signal to the driver 201. Specifically, when the value of the output voltage of the low-voltage power supply 40 is normal, the first switch device $Q_1$ and the second switch device $Q_2$ are turned off. Because of voltage division effect of $R_1$, $R_2$, and $R_3$, when the value of the output voltage of the low-voltage power supply 40 is greater than the fourth

voltage value, $Q_1$ is turned on, and $Q_2$ is also turned on after $Q_1$ is turned on. Because $Q_2$ is turned on, a level at the voltage regulator diode $D_1$ is pulled down, and the low-level signal is provided to the driver 201 as a turn-off signal. In addition, after the second switch device $Q_2$ is turned on, because a base voltage of the first switch device $Q_1$ is pulled down, even if the value of the output voltage of the low-voltage power supply 40 is restored to being less than or equal to the fourth voltage value, the first switch device $Q_1$ still remains in a turn-on state. However, that the first switch device $Q_1$ is turned on may also cause the second switch device $Q_2$ to be turned on. Therefore, the first switch device $Q_1$ and the second switch device $Q_2$ are mutually latched (which may be understood that the latch circuit 203 is latched). The latch circuit 203 may continuously provide the turn-off signal to the driver 201, so that the driver 201 controls the switch assembly 202 to continuously break the connection between the low-voltage load 30 and the low-voltage power supply 40. Until the latch circuit 203 is released from the latch state and stops providing the turn-off signal to the driver 201, the driver 201 can again control, based on the value of the output voltage of the low-voltage power supply 40, the connection between the low-voltage power supply 40 and the low-voltage load 30 to be established or broken.

Further, based on the structure shown in FIG. 10, there is a fixed association relationship between the fourth voltage value and a value of the second reference voltage. Specifically, the fourth voltage value and the value of the second reference voltage may satisfy the following formula:

$$V_2 = V_{ref2} + V_{d1} \times \left(\frac{r_1 + r_2 + r_3}{r_2}\right) (3)$$

$V_2$ is the fourth voltage value, $V_{ref2}$ is the value of the second reference voltage, $V_{d1}$ is a turn-on voltage value of the first switch device, $r_1$ is a resistance value of the first resistor $R_1$, $r_2$ is a resistance value of the second resistor $R_2$, and $r_3$ is a resistance value of the third resistor $R_3$.

Similarly, when a turn-on/turn-off speed of the first switch device $Q_1$ is not affected, the resistance value of the second resistor $R_2$ is greater than or equal to a preset resistance value. The second resistor $R_2$ with a relatively large resistance value is used, so that static power consumption of the latch circuit 203 can be effectively reduced, and energy consumption of the on board power supply apparatus 100 is further reduced.

In the foregoing implementation, the latch circuit 203 has a simple structure and low static power consumption, so that static power consumption and costs of the switch module 20 may be reduced. In addition, values of a resistor and a capacitor in the latch circuit 203 and a voltage regulation value of the voltage regulator 205 are designed, so that the switch module 20 can be applied to a plurality of power supply scenarios, and applicability of the switch module 20 may also be improved. Therefore, the circuit structure is used, so that applicability and practicability of the on board power supply apparatus 100 may be significantly improved.

In some feasible implementations, refer to FIG. 11. FIG. 11 is a schematic of a structure of still another latch circuit according to this application. As shown in FIG. 11, the latch circuit 203 includes a first switch device $Q_1$, a second switch device $Q_2$, a first resistor $R_1$, a second resistor $R_2$, a third resistor $R_3$, a fourth resistor $R_4$, a first capacitor $C_1$, and a voltage regulator diode $D_1$.

A first end of the first switch device $Q_1$ is configured to connect to a third end of the second switch device $Q_2$, a first end of the second resistor $R_2$, and a negative electrode of the voltage regulator diode $D_1$, and a positive electrode of the voltage regulator diode $D_1$ is configured to connect to the turn-off signal output terminal 2033. A second end of the first switch device $Q_1$ is configured to connect to a first end of the second resistor $R_2$, a first end of the first resistor $R_1$, and the reset signal input terminal 2034, and a second end of the first resistor $R_1$ is configured to connect to the reference voltage input terminal 2031. A third end of the first switch device $Q_1$ is configured to connect to a first end of the third resistor $R_3$, a first end of the fourth resistor $R_4$, a first end of the first capacitor $C_1$, and a first end of the second switch device $Q_2$, and a second end of the third resistor $R_3$ is configured to connect to the power supply voltage input terminal 2032. A second end of the fourth resistor $R_4$, a second end of the first capacitor $C_1$, and a second end of the second switch device $Q_2$ are configured to be grounded.

During actual working, when the switch module 20 has an overvoltage protection function, in response to that the value of the output voltage of the low-voltage power supply 40 is greater than the fourth voltage value, the first switch device $Q_1$ and the second switch device $Q_2$ are turned on and mutually latched, so that the latch circuit 203 continuously provides the turn-off signal to the driver 201. Specifically, when the value of the output voltage of the low-voltage power supply 40 is normal, the first switch device $Q_1$ and the second switch device $Q_2$ are turned off. Because of voltage division effect of the third resistor $R_3$ and the fourth resistor $R_4$, when the value of the output voltage of the low-voltage power supply 40 is greater than the fourth voltage value, $Q_2$ is turned on, and $Q_1$ is also turned on after $Q_2$ is turned on. Because $Q_2$ is turned on, a level at the voltage regulator diode $D_1$ is pulled down, and the low-level signal is provided to the driver 201 as a turn-off signal. In addition, after the second switch device $Q_2$ is turned on, because a base voltage of the first switch device $Q_1$ is pulled down, even if the value of the output voltage of the low-voltage power supply 40 is restored to being less than or equal to the fourth voltage value, the first switch device $Q_1$ still remains in a turn-on state. However, that the first switch device $Q_1$ is turned on may also cause the second switch device $Q_2$ to be turned on. Therefore, the first switch device $Q_1$ and the second switch device $Q_2$ are mutually

latched (which may be understood that the latch circuit 203 is latched). The latch circuit 203 may continuously provide the turn-off signal to the driver 201, so that the driver 201 controls the switch assembly 202 to continuously break the connection between the low-voltage load 30 and the low-voltage power supply 40. Until the latch circuit 203 is released from the latch state and stops providing the turn-off signal to the driver 201, the driver 201 can again control, based on the value of the output voltage of the low-voltage power supply 40, the connection between the low-voltage power supply 40 and the low-voltage load 30 to be established or broken.

Further, based on the structure shown in FIG. 11, the fourth voltage value may satisfy the following formula:

$$V_2 = V_{d2} \times \left( \frac{r_3 + r_4}{r_4} \right) \qquad (4)$$

$V_2$ is the fourth voltage value, $V_{d2}$ is a turn-on voltage value of the second switch device $Q_2$, $r_3$ is a resistance value of the third resistor $R_3$, and $r_4$ is a resistance value of the fourth resistor $R_4$.

In the foregoing implementation, the latch circuit 203 has a simple structure, which helps reduce costs of the switch module 20. In addition, values of a resistor and a capacitor in the latch circuit 203 and a voltage regulation value of the voltage regulator 205 are designed, so that the switch module 20 can be applied to a plurality of power supply scenarios, and applicability of the switch module 20 may also be improved. Therefore, the circuit structure is used, so that applicability and practicability of the onboard power supply apparatus 100 may be significantly improved.

It should be noted that the foregoing describes a specific structure of the latch circuit 203 provided in this application with reference to FIG. 8 to FIG. 11. This is merely an example. During actual implementation, the latch circuit 203 provided in this application may alternatively use another possible circuit structure, provided that it is ensured that the latch circuit 203 can implement the foregoing functions. A structure of the latch circuit 203 is not specifically limited in this application.

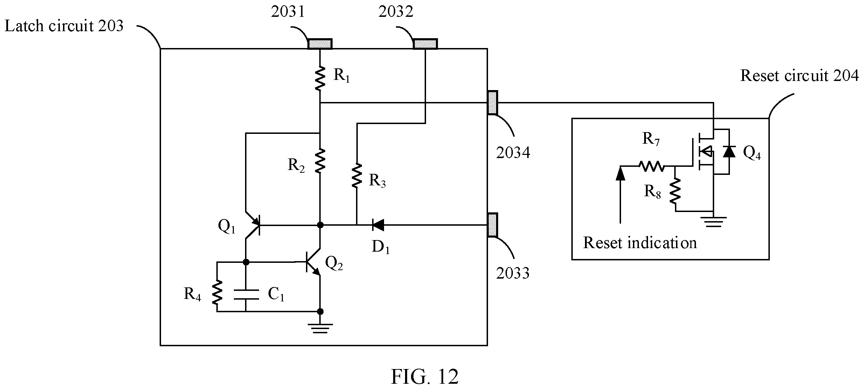

In some feasible implementations, refer to FIG. 12. FIG. 12 is a schematic of a structure of a reset circuit according to this application. It should be understood that FIG. 12 shows an example in which the latch circuit 203 uses the structure shown in FIG. 8. When the latch circuit 203 uses the structure shown in FIG. 8 to FIG. 11, a structure of the reset circuit 204, a connection relationship between the reset circuit 204 and the latch circuit 203, and a function implementation process thereof are similar. Therefore, only the structure shown in FIG. 8 is used as an example herein. As shown in FIG. 12, the reset circuit 204 may include a fourth switch device $Q_4$, a seventh resistor $R_7$, and an eighth resistor $R_8$. A first end of the fourth switch device $Q_4$ is connected to a first end of the first resistor $R_1$, a third end of the fourth switch device

$Q_4$ is separately connected to a first end of the seventh resistor $R_7$ and a first end of the eighth resistor $R_8$, and a second end of the eighth resistor $R_8$ and a second end of the fourth switch device $Q_4$ are grounded. A second end of the seventh resistor $R_7$ is used as a reset signal receiving end of the reset circuit 204, and is configured to receive the reset indication.

During actual working, in response to that the second end of the seventh resistor $R_7$ receives the reset indication, the fourth switch device $Q_4$ is turned on, so that the latch circuit 203 is released from the latch state and stops providing the turn-off signal to the driver 201. Specifically, with reference to the structure of the latch circuit 203 shown in FIG. 8, after the fourth switch device $Q_4$ is turned on, the first end of the first resistor $R_1$ and the first end of the second resistor $R_2$ are grounded, and the first switch device $Q_1$ is turned off. After the first switch device $Q_1$ is turned off, the second switch device Qz is also turned off. In this case, a level at the voltage regulator diode $D_1$ is pulled up, and the latch circuit 203 is released from the latch state and stops providing the turn-off signal to the driver 201. With reference to the structure of the latch circuit 203 shown in FIG. 9, after the fourth switch device $Q_4$ is turned on, the second switch device Qz is turned off. After the second switch device Qz is turned off, the first switch device $Q_1$ is also turned off. After the first switch device $Q_1$ is turned off, because of the voltage division relationship between the third resistor $R_3$ and the sixth resistor $R_6$, the third switch device $Q_3$ is turned on again, and the latch circuit 203 is released from the latch state and stops providing the turn-off signal to the driver 201. With reference to the structure of the latch circuit 203 shown in FIG. 10, after the fourth switch device $Q_4$ is turned on, the first end of the first resistor $R_1$ and the first end of the second resistor $R_2$ are grounded, and the first switch device $Q_1$ is turned off. After the first switch device $Q_1$ is turned off, the second switch device $Q_2$ is also turned off. In this case, a level at the voltage regulator diode $D_1$ is pulled up, and the latch circuit 203 is released from the latch state and stops providing the turn-off signal to the driver 201. With reference to the structure of the latch circuit 203 shown in FIG. 11, after the fourth switch device $Q_4$ is turned on, the first end of the first resistor $R_1$ and the first end of the second resistor $R_2$ are grounded, and the second switch device $Q_2$ is turned off. After the second switch device $Q_2$ is turned off, the first switch device $Q_1$ is also turned off. In this case, a level at the voltage regulator diode $D_1$ is pulled up, and the latch circuit 203 is released from the latch state and stops providing the turn-off signal to the driver 201.

It should be understood that the foregoing description of a specific structure of the reset circuit 204 is merely an example. During actual implementation, the reset circuit 204 provided in this application may alternatively use another possible circuit structure, provided that it is ensured that the reset circuit 204 can implement the foregoing functions. A structure of the reset circuit 204 is not specifically limited in this application.

In some feasible implementations, the driver 201 may be connected to the low-voltage power supply 40 through a power supply interface, and the driver 201 may be further connected to the latch circuit 203 through an enable interface. In this case, the turn-off signal provided by the latch circuit 203 is a disable signal of the driver 201. It should be understood that, with reference to the structure of the latch circuit 203 shown in FIG. 8 to FIG. 11, the disable signal of the driver 201 is a low-level signal. In other words, the driver 201 may be supplied power by the low-voltage power supply 40. When the switch module 20 has an undervoltage protection function, a working voltage of the driver 201 is greater than the first voltage value. When the switch module 20 has an overvoltage protection function, a working voltage of the driver 201 is less than the second voltage value. When the output voltage of the low-voltage power supply 40 is normal, the driver 201 can work only, and can also drive the switch assembly 202 to be turned on, so that the low-voltage power supply 40 and the low-voltage load 30 are connected. When the low-voltage power supply 40 is under-voltage or over-voltage, the driver 201 stops working due to abnormal power supply. In this case, the switch assembly 202 cannot be turned on, and the connection between the low-voltage power supply 40 and the low-voltage load 30 is broken. Similarly, when the low-voltage power supply 40 is under-voltage or over-voltage, which causes the latch circuit 203 to continuously output the disable signal, the driver 201 stops working because the driver 201 is disabled. In this case, the drive switch assembly 202 also cannot be turned on, and the connection between the low-voltage power supply 40 and the low-voltage load 30 is also broken.

In some feasible implementations, the first power conversion circuit 10 may include a first isolated DC/DC conversion circuit. The first isolated DC/DC conversion circuit is connected to the switch module 20. During actual working, the first isolated DC/DC conversion circuit is configured to access the high-voltage direct current, convert the high-voltage direct current into the low-voltage direct current, and provide the low-voltage direct current to the low-voltage load 30 or the low-voltage power supply 40 through the switch module 20, to supply power to the low-voltage load 30 or the low-voltage power supply 40.

For example, the first isolated DC/DC conversion circuit may include a first phase leg, a second phase leg, a first primary-side winding, a first secondary-side winding, a second secondary-side winding, and a first magnetic core. The first phase leg is used by the first isolated DC/DC conversion circuit to access a first direct current, and the second phase leg is used by the first isolated DC/DC conversion circuit to connect to the switch module 20 and output the low-voltage direct current. Both the first primary-side winding and the first secondary-side winding are wound on the first magnetic core, a dotted terminal of the first primary-side winding is connected to a midpoint of the first phase leg, and an undotted terminal of the first primary-side winding is separately connected to two ends of the first phase leg through two capacitors. A dotted terminal and an undotted terminal of the first secondary-side winding are connected to two ends of the second phase leg, a middle portion of the first secondary-side winding is connected to a midpoint of the second phase leg through a first inductor and a second capacitor that are connected in series, and two ends of the second capacitor are separately connected to the switch module 20. This is merely an example herein. During actual implementation, the first isolated DC/DC conversion circuit may also use another possible circuit structure. This is not limited herein.

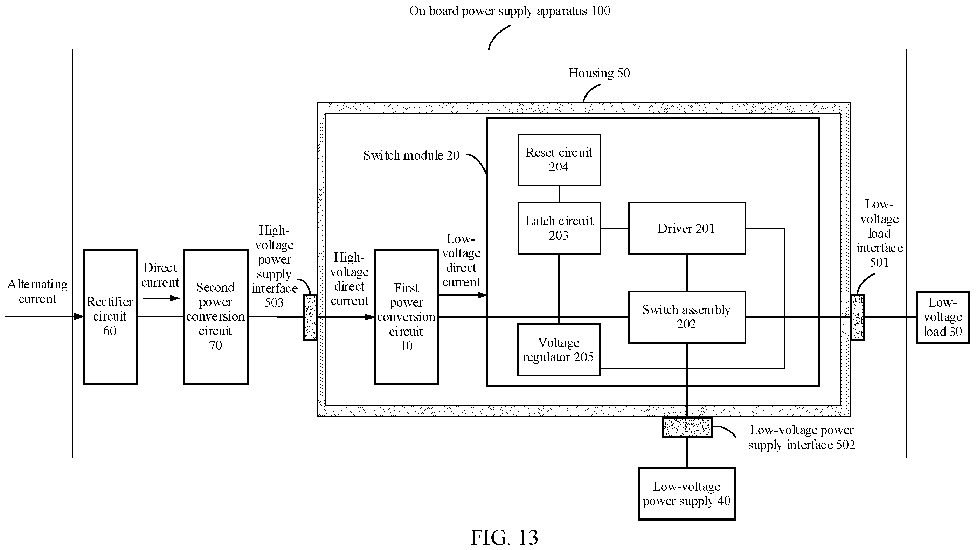

In some feasible implementations, refer to FIG. 13. FIG. 13 is a diagram of another structure of an on board power supply apparatus according to this application. As shown in FIG. 12, the on board power supply apparatus 100 may further include a rectifier circuit 60 and a second power conversion circuit 70. The rectifier circuit 60 is connected to the high-voltage power supply interface 503 through the second power conversion circuit 70.

During actual working, the rectifier circuit 60 is configured to receive an alternating current and convert the alternating current into a direct current. The second power conversion circuit 70 is configured to convert the direct current from the rectifier circuit 60 into the high-voltage direct current and supply power to the first power conversion circuit 10. The high-voltage direct current may be further used to supply power to a power battery connected to the on board power supply apparatus 100.

Optionally, the rectifier circuit 60 may be a PFC circuit, and the second power conversion circuit 70 may include a second isolated DC/DC conversion circuit. During actual working, the PFC circuit may be configured to rectify the received alternating current to obtain the direct current. The second isolated DC/DC conversion circuit is configured to convert the direct current from the PFC circuit into the high-voltage direct current, and is configured to supply power to the power battery by using the high-voltage direct current, or supply power to the first isolated DC/DC conversion circuit by using the high-voltage direct current.

For example, the second isolated DC/DC conversion circuit may include a third phase leg, a fourth phase leg, a second primary-side winding, a second secondary-side winding, a fifth phase leg, a sixth phase leg, and a second magnetic core. The third phase leg and the fourth phase leg are connected in parallel on an input side of the second isolated DC/DC conversion circuit, and the fifth phase leg and the sixth phase leg are connected in parallel on an output side of the second isolated DC/DC conversion circuit, and are connected to a second power supply interface. Both the second primary-side winding and the second secondary-side winding are wound on the second magnetic core, a dotted terminal of the second primary-side winding is connected to a midpoint of the third phase leg through a second inductor and a third capacitor that are connected in series, and an undotted terminal of the second primary-side winding is connected to a midpoint of the fourth phase leg. A dotted terminal of the second secondary-side winding is connected to a midpoint of the fifth phase leg through a fourth capacitor, and an undotted terminal of the second secondary-side winding is connected to a midpoint of the sixth phase leg. This is merely an example herein. During actual implementation, the second isolated DC/DC conversion circuit may also use another possible circuit structure. This is not limited herein.

It should be noted that FIG. 8 to FIG. 12 above merely show specific types of switch devices and connection relationships between the switch devices and other electrical components as examples. As shown in FIG. 8, a type of the first switch device $Q_1$ is a PNP-type transistor, and a type of the second switch device $Q_2$ is an NPN-type transistor. In addition, an emitter of the first switch device $Q_1$ is connected to the first resistor $R_1$, a collector of the first switch device $Q_1$ is connected to the fourth resistor $R_4$, and a base of the first switch device $Q_1$ is connected to the second resistor $R_2$. A collector of the second switch device $Q_2$ is connected to the second resistor $R_2$, an emitter of the second switch device $Q_2$ is grounded, and a base of the second switch device $Q_2$ is connected to the fourth resistor $R_4$. During actual implementation, the switch devices in the circuits provided in this application may also be other types of switch devices, such as a MOS transistor. Alternatively, a mix of a transistor and a MOS transistor may be used for implementation. In addition, a specific connection manner of the switch devices may also be adjusted according to a requirement. In short, a type and a connection manner of the switch devices in this application are not specifically limited, provided that a corresponding function can be implemented.

It should be further noted that the alternating current in this application may come from an external power supply of the electric vehicle in which the on board power supply apparatus 100 is located. The external power supply may be an alternating current power grid, an alternating current charging pile, an uninterruptible power supply (uninterruptible power system, UPS), or the like. In this case, the external power supply may also be referred to as an alternating current power supply.

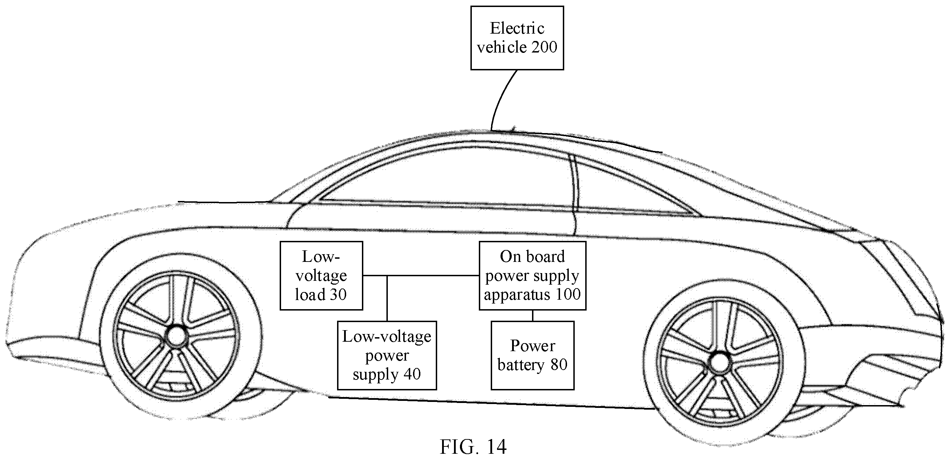

This application further provides an electric vehicle. FIG. 14 is a diagram of a structure of still another electric vehicle according to this application. As shown in FIG. 14, the electric vehicle 200 may include the on board power supply apparatus 100 provided in this application. Further, the electric vehicle 200 may include the low-voltage load 30, the low-voltage power supply 40, and a power battery 80. During actual working, the electric vehicle 200 may supply power to the low-voltage load 30, the low-voltage power supply 40, and the power battery 80 through the on board power supply apparatus 100.

It should be understood that FIG. 14 is merely an example. During actual implementation, the electric vehicle 200 may further include other functional components such as a motor and an on board computer. To avoid repetition, the other functional components are not enumerated in FIG. 14.

It should be further noted that the electric vehicle 200 in this application may include a pure electric vehicle (pure electric vehicle/battery electric vehicle, PEV/BEV), a hybrid electric vehicle (hybrid electric vehicle, HEV), a range extended electric vehicle (range extended electric vehicle, REEV), a plug-in hybrid electric vehicle (plug-in hybrid electric vehicle, PHEV), a new energy vehicle (new energy vehicle), or the like.

An "embodiment" mentioned in the specification indicates that a particular feature, structure, or characteristic described with reference to this embodiment may be included in at least one embodiment of this application. The phrase shown in various locations in the specification may not necessarily refer to a same embodiment, and is not an independent or optional embodiment exclusive from another embodiment. It is explicitly and implicitly understood by a person skilled in the art that embodiments described in the specification may be combined with another embodiment.

In the foregoing specific implementations, the objectives, technical solutions, and beneficial effects of this application are further described in detail. It should be understood that the foregoing descriptions are merely specific implementations of this application, but are not intended to limit the protection scope of this application. Any modification, equivalent replacement, improvement, or the like made based on the technical solutions of this application shall fall within the protection scope of this application.

**Claims**

1. An on board power supply apparatus, wherein the on board power supply apparatus comprises a first power conversion circuit and a switch module, and the switch module comprises a driver, a switch assembly, and a latch circuit, wherein

> the first power conversion circuit is configured to receive a high-voltage direct current and output a low-voltage direct current;
> a low-voltage load is configured to receive the low-voltage direct current or receive an output voltage of a low-voltage power supply through the switch assembly, wherein a voltage of the low-voltage direct current and the output voltage of the low-voltage power supply are less than a voltage of the high-voltage direct current; and
> in a process in which the low-voltage power supply supplies power to the low-voltage load through the switch assembly, the driver is configured to:

> in response to a turn-off signal output by the latch circuit, control the switch assembly to break a connection between the low-voltage power supply and the low-voltage load until the latch circuit stops outputting the turn-off signal.

2. The on board power supply apparatus according to claim 1, wherein the switch module comprises a reset circuit, the reset circuit is configured to receive a reset indication and output a reset signal to the latch circuit, and the latch circuit is configured to:

> in response to that a value of the output voltage of the low-voltage power supply= is less than a first voltage value or greater than a second voltage value, output the turn-off signal until the reset signal is received; and
> in response to the reset signal, stop outputting the turn-off signal.

3. The on board power supply apparatus according to claim 1 or 2, wherein the on board power supply apparatus comprises a housing configured to accommodate the first power conversion circuit and the switch module, and a low-voltage load interface, a low-voltage power supply interface, and a high-voltage power supply interface are disposed on a surface of the housing, wherein

> the low-voltage power supply interface is electrically connected to the low-voltage load interface;
> the first power conversion circuit is configured to receive the high-voltage direct current through the high-voltage power supply interface;
> the low-voltage power supply interface is configured to receive power from the low-voltage power supply; and
> the low-voltage load interface is configured to electrically connect to the low-voltage load.

4. The on board power supply apparatus according to any one of claims 1 to 3, wherein the switch module comprises a voltage regulator, the voltage regulator is configured to receive power from the low-voltage power supply and output a first reference voltage or a second reference voltage to the latch circuit, and the first reference voltage or the second reference voltage is used to control the latch circuit to work normally.

5. The on board power supply apparatus according to claim 4, wherein the latch circuit comprises a reference voltage input terminal, a power supply voltage input terminal, a reset signal input terminal, and a turn-off signal output terminal, and the latch circuit is configured to:

receive an output voltage from the voltage regulator through the reference voltage input terminal;

receive the reset signal from the reset circuit through the reset signal input terminal;

receive the output voltage of the low-voltage power supply through the power supply voltage input terminal; and

output the turn-off signal to the driver through the turn-off signal output terminal.

6. The on board power supply apparatus according to claim 5, wherein the latch circuit comprises a first switch device, a second switch device, a first resistor, a second resistor, a third resistor, a fourth resistor, a first capacitor, and a voltage regulator diode, wherein

a first end of the first switch device is configured to connect to a third end of the second switch device, a first end of the second resistor, a first end of the third resistor, and a negative electrode of the voltage regulator diode, a second end of the third resistor is connected to the power supply voltage input terminal, and a positive electrode of the voltage regulator diode is connected to the turn-off signal output terminal;

a second end of the first switch device is configured to connect to a second end of the second resistor, a first end of the first resistor, and the reset signal input terminal, and a second end of the first resistor is connected to the reference voltage input terminal; and

a third end of the first switch device is configured to connect to a first end of the fourth resistor, a first end of the first capacitor, and a first end of the second switch device, and a second end of the fourth resistor, a second end of the first capacitor, and a second end of the second switch device are grounded.

7. The on board power supply apparatus according to claim 5, wherein in response to that the value of the output voltage of the low-voltage power supply is less than a third voltage value, both the first switch device and the second switch device are turned on, and the latch circuit is configured to output the turn-off signal; or

in response to that a value of the output voltage of the low-voltage power supply is greater than or equal to a third voltage value, or in response to the reset signal, both the first switch device and the second switch device are turned off, and the latch circuit stops outputting the turn-off signal.

8. The on board power supply apparatus according to claim 5, wherein the latch circuit comprises a first switch device, a second switch device, a third switch device, a first resistor, a second resistor, a third resistor, a fourth resistor, a fifth resistor, a sixth resistor, a first capacitor, and a voltage regulator diode, wherein

a first end of the first switch device is configured to connect to a third end of the second switch device, a first end of the second resistor, and a negative electrode of the voltage regulator diode, and a positive electrode of the voltage regulator diode is configured to connect to the turn-off signal output terminal;

a second end of the first switch device is configured to connect to a first end of the fifth resistor, a second end of the second resistor, a first end of the first resistor, and the reset signal input terminal, and a second end of the first resistor is configured to connect to the reference voltage input terminal;

a third end of the first switch device is configured to connect to a second end of the fifth resistor, a third end of the third switch device, a first end of the fourth resistor, a first end of the first capacitor, and a first end of the second switch device, a first end of the third switch device is configured to connect to a first end of the third resistor and a first end of the sixth resistor, and a second end of the third resistor is configured to connect to the power supply voltage input terminal; and

a second end of the sixth resistor, a second end of the third switch device, a second end of the fourth resistor, a second end of the first capacitor, and a second end of the second switch device are grounded.

9. The on board power supply apparatus according to claim 8, wherein in response to that a value of the output voltage of the low-voltage power supply is less than a third voltage value, the third switch device is turned off, both the second switch device and the first switch device are turned on, and the latch circuit is configured to output the turn-off signal; or

in response to that a value of the output voltage of the low-voltage power supply is greater than or equal to a third voltage value, or in response to the reset signal, the third switch device is turned on, both the first switch device and the second switch device are turned off, and the latch circuit stops outputting the turn-off signal.

10. The on board power supply apparatus according to claim 5, wherein the latch circuit comprises a first switch device, a second switch device, a first resistor, a second resistor, a third resistor, a fourth resistor, a first capacitor, and a voltage regulator diode, wherein

a first end of the first switch device is configured to connect to a third end of the second switch device, a first end of the second resistor, a first end of the third resistor, and a negative electrode of the voltage regulator diode, a second end of the third resistor is connected to the reference voltage input terminal, and a positive electrode of the voltage regulator diode is connected to the turn-off signal output terminal;

a second end of the first switch device is configured to connect to a second end of the second resistor, a first end of the first resistor, and the reset signal input terminal, and a second end of the first resistor is connected to the power supply voltage input terminal; and

a third end of the first switch device is configured to connect to a first end of the fourth resistor, a first end of the first capacitor, and a first end of the second switch device, and a second end of the fourth resistor, a second end of the first capacitor, and a second end of the second switch device are grounded.

11. The on board power supply apparatus according to claim 5, wherein the latch circuit comprises a first switch device, a second switch device, a first resistor, a second resistor, a third resistor, a fourth resistor, a first capacitor, and a voltage regulator diode, wherein

a first end of the first switch device is configured to connect to a third end of the second switch device, a first end of the second resistor, and a negative electrode of the voltage regulator diode, and a positive electrode of the voltage regulator diode is configured to connect to the turn-off signal output terminal;

a second end of the first switch device is configured to connect to a first end of the second resistor, a first end of the first resistor, and the reset signal input terminal, and a second end of the first resistor is configured to connect to the reference voltage input terminal;

a third end of the first switch device is configured to connect to a first end of the third resistor, a first end of the fourth resistor, a first end of the first capacitor, and a first end of the second switch device, and a second end of the third resistor is configured to connect to the power supply voltage input terminal; and

a second end of the fourth resistor, a second end of the first capacitor, and a second end of the second switch device are configured to be grounded.

12. The on board power supply apparatus according to claim 10 or 11, wherein in response to that the output voltage of the low-voltage power supply is greater than a fourth voltage value, both the first switch device and the second switch device are turned on, and the latch circuit outputs the turn-off signal; or in response to that the output voltage of the low-voltage power supply is greater than or equal to a fourth voltage value, or in response to the reset signal, both the first switch device and the second switch device are turned off, and the latch circuit stops outputting the turn-off signal.

13. The on board power supply apparatus according to any one of claims 7 to 12, wherein the reset circuit comprises a fourth switch device, a seventh resistor, and an eighth resistor, wherein

a first end of the fourth switch device is configured to connect to the reset signal input terminal;
a second end of the fourth switch device is configured to be grounded; and
a third end of the fourth switch device is configured to receive the reset indication through the seventh resistor, and connect to the second end of the fourth switch device through the eighth resistor.

14. The on board power supply apparatus according to any one of claims 1 to 13, wherein the on board power supply apparatus further comprises a rectifier circuit and a second power conversion circuit, the rectifier circuit is configured to receive an alternating current and convert the alternating current into a direct current, the second power conversion circuit is configured to convert the direct current into the high-voltage direct current and supply power to the first power conversion circuit, and the high-voltage direct current is further used to supply power to a power battery.

15. An electric vehicle, wherein the electric vehicle comprises the on board power supply apparatus according to any one of claims 1 to 14.

Electric vehicle

| Alternating current | → | On board charger | → High-voltage direct current | Power battery |

High-voltage direct current ↓

| Low-voltage power supply | | Switch module | ← Low-voltage direct current | On board DC/DC converter |
| Low-voltage load | | | | |

FIG. 1

FIG. 2

On board power supply apparatus 100

Switch module 20

Latch circuit 203 — Driver 201

High-voltage direct current → First power conversion circuit 10 → Low-voltage direct current

Switch assembly 202

Low-voltage load 30

Low-voltage power supply 40

FIG. 3

On board power supply apparatus 100

FIG. 4

FIG. 5

EP 4 530 124 A1

On board power supply apparatus 100

Housing 50

High-voltage power supply interface 503

High-voltage direct current

First power conversion circuit 10

Low-voltage direct current

Switch module 20

Reset circuit 204

Latch circuit 203

Driver 201

Voltage regulator 205

Switch assembly 202

Low-voltage load interface 501

Low-voltage load 30

Low-voltage power supply interface 502

Low-voltage power supply 40

FIG. 6

EP 4 530 124 A1

FIG. 7

FIG. 8

FIG. 9

FIG. 10

FIG. 11

Latch circuit 203

2031    2032

Reset circuit 204

$R_1$

$R_7$    $Q_4$

$R_2$    $R_3$

2034

$R_8$

$Q_1$    $D_1$

Reset indication

$Q_2$

2033

$R_4$    $C_1$

FIG. 12

On board power supply apparatus 100

Housing 50

Switch module 20

Reset circuit 204

Latch circuit 203

Driver 201

Voltage regulator 205

Switch assembly 202

Low-voltage load interface 501

Low-voltage load 30

First power conversion circuit 10

High-voltage direct current

Low-voltage direct current

High-voltage power supply interface 503

Second power conversion circuit 70

Direct current

Rectifier circuit 60

Alternating current

Low-voltage power supply interface 502

Low-voltage power supply 40

FIG. 13

FIG. 14

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2005/029867 A1 (WOOD STEVEN J [US]) 10 February 2005 (2005-02-10) * figures 1A,1B,2A,2B,3B,3C * * paragraphs [0002], [0025], [0026], [0037], [0041], [0018] - [0020] * ----- | 1-15 | INV. B60L58/12 B60L58/20 G05F1/575 G06F1/26 G06F1/30 |
| Y | US 5 488 283 A (DOUGHERTY THOMAS J [US] ET AL) 30 January 1996 (1996-01-30) * figure 6 * * column 12, lines 45-54 * * column 14, lines 57-62 * ----- | 1-15 | H02H3/093 H02H3/20 H02H3/24 H02J1/08 H02M1/36 H03K17/22 |
| A | US 2014/117937 A1 (CHO WON JIN [KR]) 1 May 2014 (2014-05-01) * figure 1 * ----- | 14 | B60L53/14 |

**TECHNICAL FIELDS SEARCHED (IPC)**

B60L
G05F
G06F
H02H
H02J
H02M
H03K

The present search report has been drawn up for all claims

| Place of search | Date of completion of the search | Examiner |
|---|---|---|
| The Hague | 17 February 2025 | Herrera Caballero, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 3003

This annex lists the patent family members relating to the patent documents cited in the above-mentioned European search report.
The members are as contained in the European Patent Office EDP file on
The European Patent Office is in no way liable for these particulars which are merely given for the purpose of information.

17-02-2025

| Patent document cited in search report | | Publication date | Patent family member(s) | | Publication date |
|---|---|---|---|---|---|
| US 2005029867 | A1 | 10-02-2005 | AU | 2002333556 A1 | 24-03-2003 |
| | | | EP | 1428304 A2 | 16-06-2004 |
| | | | US | 2005029867 A1 | 10-02-2005 |
| | | | WO | 03023936 A2 | 20-03-2003 |
| US 5488283 | A | 30-01-1996 | NONE | | |
| US 2014117937 | A1 | 01-05-2014 | KR | 20140054796 A | 09-05-2014 |
| | | | US | 2014117937 A1 | 01-05-2014 |

EPO FORM P0459

For more details about this annex : see Official Journal of the European Patent Office, No. 12/82